# EUROPÄISCHE PATENTSCHRIFT

(11) **EP 1 728 280 B1**
(45) Veröffentlichungstag und Bekanntmachung des Hinweises auf die Patenterteilung: **17.05.2017**
(21) Anmeldenummer: 05715076.5
(22) Anmeldetag: 09.03.2005
(51) Int. Cl.: H01L 31/0203, H01L 31/0232, H01L 33/48, H01L 33/60, H01L 33/54, H01S 5/022

(54) **OPTOELEKTRONISCHES BAUTEIL MIT MEHRTEILIGEM GEHÄUSEKÖRPER**
OPTOELECTRONIC COMPONENT COMPRISING A MULTI-PART HOUSING BODY
COMPOSANT OPTOÉLECTRONIQUE POURVUE D'UN CORPS DE BOÎTIER EN PLUSIEURS PARTIES

(30) Priorität: 23.03.2004 DE 102004014207
(43) Veröffentlichungstag der Anmeldung: 06.12.2006
(73) Patentinhaber: OSRAM Opto Semiconductors GmbH, 93055 Regensburg (DE)
(72) Erfinder: BRUNNER, Herbert, 93161 Sinzing (DE); WINTER, Matthias, 93059 Regensburg (DE); ZEILER, Markus, 93152 Nittendorf (DE); BOGNER, Georg, 93138 Lappersdorf (DE); HÖFER, Thomas, 93138 Lappersdorf (DE)
(74) Vertreter: Epping - Hermann - Fischer
(86) Internationale Anmeldenummer: PCT/DE2005/000411
(87) Internationale Veröffentlichungsnummer: WO 2005/093853

(56) Entgegenhaltungen:
- WO-A-00/02262
- DE-A1- 10 227 515
- DE-A1- 10 229 067
- US-A- 6 066 861

## Beschreibung

Die Erfindung betrifft ein optoelektronisches Bauteil gemäß dem Oberbegriff des Patentanspruchs 1.

Derartige optoelektronische Bauteile werden häufig mit Gehäusekörpern realisiert, die als Premolded-Gehäusebauform, ausgebildet sind. Der Gehäusekörper wird hierbei, wie etwa gemäß der US 6,459,130, durch Umspritzen eines metallischen Leiterrahmens mit einem Kunststoff hergestellt, wobei auf dem Leiterrahmen nachfolgend ein optoelektronischer Halbleiterchip angeordnet wird. Dieser Kunststoff ist mit einem reflexionssteigerndem Material bezüglich einer vom Halbleiterchip zu erzeugenden Strahlung versehen. Die im Betrieb des Bauteils am Halbleiterchip entstehende Wärme wird aufgrund der relativ geringen thermischen Leitfähigkeit des Kunststoffs zum Großteil über den Leiterrahmen aus dem Gehäusekörper geleitet. Die Gefahr einer Delamination des Materials des Gehäusekörpers vom Leiterrahmen und folglich der Einwirkung schädigender äußerer Einflüsse auf den Halbleiterchip kann dadurch erhöht werden. Weiterhin kann die Reflektivität des Kunststoffes durch auf den Kunststoff einfallende Strahlung, wie beispielsweise ultraviolette Strahlung, aufgrund von Verfärbungen vermindert werden, so dass die Effizienz des Bauteils reduziert werden kann.

Ferner sind Gehäusekörper aus Keramikmaterialien bekannt, die sich oftmals durch eine hohe Wärmeleitfähigkeit auszeichnen. In herkömmlichen optoelektronischen Bauteilen dieser Art ist die Wand des Gehäusekörpers derart metallisiert, dass die Metallisierung einen Reflektor ausbildet. Weiterhin sind die Anschlussleiter zur Kontaktierung des Halbleiterchips, wie etwa in der JP 09-045965, häufig auch aus dieser Metallisierung gebildet. Das Metall bildet hierbei das Anschlussleitermaterial und das Reflektormaterial.

In der Druckschrift DE 102 27 515 A1 ist ein Lichtemissionsdiodengerät beschrieben, bei dem eine reflektierende Platte aus Metall innerhalb einer Ausnehmung in einem keramischen Substrat angeordnet ist, wobei die Platte einen LED-Chip des Lichtemissionsdiodengeräts umfasst.

Eine Aufgabe der Erfindung ist es, ein optoelektronisches Bauteil der oben genannten Art anzugeben, dass sich durch vorteilhaft hohe Effizienz auszeichnet.

Diese Aufgabe wird durch ein optoelektronisches Bauteil mit den Merkmalen des Patentanspruchs 1 gelöst. Vorteilhafte Weiterbildungen sind Gegenstand der abhängigen Patentansprüche.

Ein erfindungsgemäßes optoelektronisches Bauteil umfasst einen Gehäusekörper und mindestens einen auf dem Gehäusekörper angeordneten Halbleiterchip. Der Gehäusekörper weist hierbei ein Grundteil, das einen Anschlusskörper umfasst, auf dem ein Anschlussleitermaterial angeordnet ist, sowie ein Reflektorteil auf, das einen Reflektorkörper umfasst, auf dem ein Reflektormaterial angeordnet ist, wobei der Anschlusskörper und der Reflektorkörper getrennt voneinander vorgeformt sind, und der Reflektorkörper in Form eines Reflektoraufsatzes auf dem Anschlusskörper angeordnet ist. Der Reflektorkörper kann insbesondere mit dem Reflektormaterial beschichtet sein.

Dadurch, dass der Gehäusekörper einen Anschlusskörper und einen Reflektorkörper umfasst, die getrennt voneinander vorgeformt sind, hat die Ausgestaltung eines derartigen Gehäusekörpers vorteilhaft hohe Freiheitsgrade, insbesondere hinsichtlich der Formgebungen des Anschluss- und des Reflektorkörpers. So kann beispielsweise ein Standardanschlusskörper vorgeformt werden, der mit verschieden ausgebildeten Reflektoraufsätzen versehen werden kann. Entsprechendes gilt für verschieden ausgebildete Anschlusskörper, so dass insgesamt vorteilhaft hohe Freiheitsgrade bezüglich der Ausgestaltung des Gehäusekörpers gegeben sind, der einen vorgeformten Anschlusskörper und einen vorgeformten Reflektorkörper umfasst. Derartige Gehäusekörper können kostengünstig in den verschiedensten Ausgestaltungen hergestellt werden. Weiterhin kann der Reflektorkörper auf individuelle Erfordernisse, die Abstrahl- oder Empfangscharakteristik des optoelektronischen Bauteils betreffend abgestimmt werden.

Das optoelektronische Bauteil kann als Sender oder Empfänger ausgebildet sein. Das Bauteil umfasst hierzu vorzugsweise zumindest einen optoelektronischen Halbleiterchip, der beispielsweise als LED-Chip, Laserdiodenchip oder Photodiodenchip realisiert sein kann. Das optoelektronische Bauteil kann zusätzlich auch andere Halbleiterchips, wie beispielsweise einen IC-Chip enthalten, die beispielsweise der Ansteuerung des optoelektronischen Bauteils dienen können.

Zur Strahlungserzeugung oder zum Strahlungsempfang umfasst der optoelektronische Halbleiterchip vorzugsweise eine aktive Zone, die beispielsweise für elektromagnetische Strahlung, etwa im ultravioletten bis infraroten Spektralbereich, ausgebildet sein kann. Die aktive Zone und/oder der Halbleiterchip enthalten bevorzugt ein III-V-Halbleitermaterial, wie InₓGa_{y}Al_{1-x-y}P, InₓGaAl_{1-x-y}N oder InₓGa_{y}Al_{1-x-y}As, jeweils mit 0≤x≤1, 0≤y≤1 und x+y≤1.

Das Materialsystem InₓGa_{y}Al_{1-x-y}N zum Beispiel ist für Strahlung im ultravioletten bis grünen Spektralbereich besonders geeignet, während InₓGa_{y}Al_{1-x-y}P beispielsweise für Strahlung im grüngelben bis infraroten Spektralbereich besonders geeignet ist.

Als Strahlungsempfänger sind auch Si enthaltende oder Sibasierende Halbleiterchips, wie beispielsweise Si-Photodiodenchips, geeignet.

Bevorzugt wird während der Vorformung des Anschlussbeziehungsweise des Reflektorkörpers das Anschlussleiter- und/oder das Reflektormaterial auf dem Anschlussbeziehungsweise dem Reflektorkörper angeordnet, so dass auch das Grundteil und das Reflektorteil des Gehäusekörpers getrennt voneinander vorgeformt sind.

Durch die getrennte Vorformung des Grundteils und des Reflektorteils können das Reflektor- und das Anschlussleitermaterial unabhängig voneinander entsprechend der jeweiligen vorteilhaften Eigenschaften - beispielsweise hinsichtlich der Reflektivität oder der Leitfähigkeit - innerhalb der Fertigungsmöglichkeiten prinzipiell frei gewählt werden.

Das vorgeformte Reflektorteil ist mit dem vorgeformten Grundteil bevorzugt dauerhaft mechanisch zusammengefügt, so dass der Gehäusekörper eine vorteilhaft hohe Stabilität aufweist und den Halbleiterchip dadurch vor schädlichen äußeren Einwirkungen schützt.

Besonders bevorzugt ist im Gehäusekörper zwischen dem Grundteil und dem Reflektorteil, die insbesondere getrennt voneinander vorgeformt sind, ein Verbindungsbereich ausgebildet, mittels dem das Reflektorteil und das Grundteil mechanisch stabil verbunden sind.

Die Verbindung des Reflektorteils und des Grundteils kann beispielsweise über eine Klebstoff- oder eine Sinterverbindung erfolgen, die mit Vorzug im Verbindungsbereich ausgebildet ist. Der Sintervorgang erfolgt hierbei bevorzugt nach der getrennten Vorformung des Reflektor- und des Gehäuseteils.

In einer ersten bevorzugten Ausgestaltung der Erfindung ist das Anschlussleitermaterial in mindestens zwei elektrisch voneinander isolierten Teilbereichen auf dem Anschlusskörper angeordnet, die vorzugsweise zumindest teilweise die Anschlussleiter zur elektrischen Kontaktierung des Halbleiterchips bilden, der hierzu mit dem Anschlussleitermaterial leitend verbunden ist. Beispielsweise ist der Halbleiterchip mit einem Teilbereich des Anschlussleitermaterials über eine Lot- oder Klebeverbindung und mit einem weiteren Teilbereich über eine Bondverbindung, wie einen Bonddraht, elektrisch leitend verbunden.

Das Anschlussleiter- und/oder das Reflektormaterial enthalten bevorzugt ein Metall, besonders bevorzugt, Ag, Al, Pt, Pd, W, Ni, Au oder eine Legierung mit mindestens einem dieser Metalle. Diese Metalle können sich durch eine vorteilhaft hohe Leitfähigkeit auszeichnen. Je nach Wellenlänge der erzeugten oder empfangenen Strahlung können sich diese Materialien auch durch eine vorteilhaft hohe Reflektivität bezüglich dieser Strahlung auszeichnen. Au beispielsweise zeichnet sich durch eine hohe Reflektivität vom infraroten bis zum gelbgrünen Spektralbereich aus, während beispielsweise Ag und Al auch im grünen, blauen und ultravioletten Spektralbereich eine hohe Reflektivität aufweisen können.

In einer vorteilhaften Weiterbildung enthält das Anschlussleitermaterial Au und/oder ist im wesentlichen frei von Ag, da sich Ag-Atome durch Migration in den Halbleiterchip schädlich auf die Funktion des Chips auswirken können. Au zeichnet sich durch vorteilhafte Löteigenschaften aus, so dass vorzugsweise zumindest die dem Halbleiterchip zugewandte Oberfläche des Anschlussleitermaterials im Falle einer Lotverbindung Au enthält.

Da sich Ag häufig durch eine vorteilhaft hohe Reflektivität, insbesondere im ultravioletten bis infraroten Spektralbereich, bezüglich einer von einem optoelektronischen Halbleiterchip zu erzeugenden oder zu empfangenden Strahlung auszeichnet, enthält das Reflektormaterial bevorzugt Ag. Insbesondere gilt dies für die Reflektivität von Ag im Vergleich zu der von Au im blauen oder ultravioletten Spektralbereich, da Au in diesem Spektralbereich relativ stark absorbiert.

Durch die verschiedenen Materialien des Anschluss- und des Reflektormaterials können die vorteilhaften Eigenschaften des jeweiligen Materials - beispielsweise hohe Reflektivität und hohe Leitfähigkeit - ausgenutzt werden, während die Gefahr negativer Beeinflussung der Funktion oder der Effizienz des Bauteils bedingt durch diese Materialien, wie die Schädigung des Halbleiterchips oder vergleichsweise geringe Reflektivität, verringert werden kann.

Das Reflektormaterial kann den Reflektorkörper mit Vorteil vor dem Einfall von UV-Strahlung schützen. Alterungserscheinungen des Gehäusekörpers, wie beispielsweise Rissbildung, Veränderungen der Oberfläche beziehungsweise der Struktur der Oberfläche oder Verfärbungen, können so, insbesondere im Vergleich zu einer herkömmlichen Premolded-Gehäusebauform ohne metallisches Reflektormaterial, verringert werden.

In einer bevorzugten Ausgestaltung des Gehäusekörpers enthält dieser zumindest eine Keramik, besonders bevorzugt eine Aluminiumnitrid oder Aluminiumoxid enthaltende Keramik, die sich durch eine vorteilhaft hohe Wärmeleitfähigkeit beziehungsweise einen vorteilhaft geringen thermischen Widerstand auszeichnen kann. Der thermische Widerstand eines Gehäusekörpers, der eine der oben genannten Keramiken enthält, kann beispielsweise 10 K/W oder weniger betragen. Ein optoelektronisches Bauteil, dessen Gehäusekörper eine Keramik, beispielsweise auf AlN oder Al₂O₃ basierend, enthält, kann, insbesondere verglichen mit einer Premolded-Gehäusebauform, eine vorteilhaft erhöhte Stabilität gegenüber hohen Temperaturen oder Temperaturschwankungen aufweisen.

Verglichen mit herkömmlichen Premolded-Gehäusebauformen mit umspritzten Leiterrahmen, bei denen der Leiterrahmen einen Großteil der Wärmeableitung übernimmt, kann so, wegen der vorteilhaft hohen Wärmeleitfähigkeit der Keramik, die am Halbleiterchip entstehende Wärme auch vermehrt über den Gehäusekörper abtransportiert werden.

Im Bereich des Halbleiterchips kann beispielsweise im Betrieb eines als Hochleistungschips ausgebildeten Halbleiterchips oder beim Befestigen des Halbleiterchips am Gehäusekörper über eine Lötverbindung eine beträchtliche Wärme entstehen. Bei herkömmlichen Premolded-Gehäusebauformen kann durch diese Wärme die Gefahr der Delamination des Gehäusematerials vom Leiterrahmen erhöht werden, was sich wiederum schädlich auf die Funktion des Bauteils auswirken kann.

Bevorzugt enthält zumindest der Anschlusskörper eine Keramik, die über das Anschlussleitermaterial thermisch leitend mit dem Halbleiterchip verbunden ist, so dass zumindest der Teil des Gehäusekörpers, auf dem der Halbleiterchip angeordnet ist, eine vorteilhaft hohe Wärmeleitfähigkeit aufweist und die Wärmeableitung vom Halbleiterchip auch vorteilhaft über den Anschlusskörper erfolgen kann.

Die Vorformung des Anschluss- und des Reflektorkörpers, beziehungsweise des Grund- und des Reflektorteils, die eine Keramik enthalten, erfolgt bevorzugt, während die Keramik in Form einer zähen Paste, einem sogenannten Green-Sheet (Grünblatt) vorliegt. Dieses Green-Sheet ist mit Vorteil formbeständig bezüglich der in ihm vorgesehener Strukturen, die mit besonderem Vorteil denen der Elemente des Gehäusekörpers, wie dem Anschluss- oder dem Reflektorkörper, entsprechen. In einem Green-Sheet können Strukturen für die verschiedenen Gehäusekörperteile, beispielsweise durch Stanzen, ausgebildet werden.

In einer weiteren vorteilhaften Ausgestaltung umfasst der Gehäusekörper eine Wärmesenke, die bevorzugt zumindest teilweise vom Anschlusskörper umgeben oder umformt ist. Mit Vorteil kann die Wärmesenke während der Vorformung des den Anschlusskörper umfassenden Grundteils vorgesehen werden. Die Wärmesenke ist weiterhin bevorzugt vom Halbleiterchip beziehungsweise dem Anschlussleitermaterial elektrisch isoliert.

Thermisch ist die Wärmesenke besonders bevorzugt gut leitend mit dem Halbleiterchip verbunden. Die Wärmeableitung vom Halbleiterchip wird dadurch vorteilhaft verbessert. Mit Vorteil wird durch eine vom Anschlusskörper zumindest teilweise umformte oder umgebene Wärmesenke der Transportweg, den die Wärme beim Wärmeabtransport vom Halbleiterchip zurücklegt, gegenüber einem Transport über die Anschlussleiter beziehungsweise den Leiterrahmen des Halbleiterchips vorteilhaft verkürzt.

Die Wärmesenke kann in einer vorteilhaften Weiterbildung der Erfindung von der dem Halbleiterchip gegenüberliegenden Seite des Anschlusskörpers thermisch gut leitend mit einem externen Kühlkörper verbunden werden, so dass die Gefahr einer Schädigung des Halbleiterchips beziehungsweise des Gehäusekörpers gegenüber hohen Temperaturschwankungen, wie beim Befestigen des Halbleiterchips auf dem Grundteil über eine Lötverbindung, verringert wird.

In einer weiteren bevorzugten Ausgestaltung der Erfindung weist das optoelektronische Bauteil einen thermischen Anschluss auf. Der thermische Anschluss kann bei einer Montage des Bauteils thermisch leitend mit einem externen Kühlkörper verbunden werden. Bevorzugt enthält der thermische Anschluss ein Metall. Der thermische Anschluss kann auf dem Gehäusekörper angeordnet sein. Bevorzugt ist der thermische Anschluss auf einer dem Halbleiterchip gegenüber liegenden Seite des Gehäusekörpers, insbesondere des Anschlusskörpers, angeordnet. Der thermische Anschluss ist bevorzugt aus dem Anschlussleitermaterial gebildet. Der thermische Anschluss kann bei der Vorformung des Grundteiles ausgebildet werden.

Die Wärmeableitung vom Halbleiterchip zum thermischen Anschluss kann hierbei im wesentlichen vollständig durch das Material des Gehäusekörpers, insbesondere des Anschlusskörpers, erfolgen. Insbesondere kann der Gehäusekörper vereinfacht als Wärmesenke ausgeführt sein. Auf das Vorsehen einer separaten Wärmesenke, insbesondere im Anschlusskörper, kann mit Vorteil verzichtet werden. Der thermische Anschluss kann vielmehr auf der Oberfläche des Gehäusekörpers angeordnet sein. Der thermische Anschluss kann ferner, insbesondere vollständig, außerhalb des Gehäusekörpers, insbesondere des Anschlusskörpers, angeordnet sein. Bevorzugt ist der thermische Anschluss auf dem Anschlusskörper angeordnet.

Bevorzugt enthält der Gehäusekörper, insbesondere der Anschlusskörper, bei einem separat ausgebildeten thermischen Anschluss eine Keramik, die besonders bevorzugt eine hohe Wärmeleitfähigkeit aufweist.

Ferner kann der thermische Anschluss mit, insbesondere genau, einem, der mittels des Anschlussleitermaterials gebildeten elektrischen Anschlussleiter elektrisch leitend verbunden sein. Dies erleichtert eine großflächige Ausbildung des thermischen Anschlusses, wobei der Gehäusekörper, insbesondere der Anschlusskörper, mit Vorteil zum Ausbilden eines großflächigen thermischen Anschlusses nicht vergrößert werden muss. Zweckmäßigerweise ist der thermische Anschluss hierbei derart angeordnet, dass eine direkte elektrische leitende Verbindung zwischen zwei Anschlussleitern und ein hieraus resultierender Kurzschluss vermieden wird.

Insbesondere kann der thermische Anschluss einstückig mit, insbesondere genau, einem Anschlussleiter ausgebildet sein.

Der Gehäusekörper weist weiterhin zumindest eine Ausnehmung auf, in der der Halbleiterchip angeordnet ist. Die Ausnehmung ist vorzugsweise zumindest teilweise in Form einer Aussparung im Reflektorkörper vorgesehen und/oder das Reflektormaterial ist vorzugsweise zumindest teilweise auf der Wand der Aussparung angeordnet.

Die Wand der Ausnehmung oder der Aussparung ist vorzugsweise mit einer durchgehenden Schicht des Reflektormaterials versehen, das mit Vorteil die Reflektivität gegenüber einer unbeschichteten Wand erhöht.

Durch die Form der Aussparung beziehungsweise der Ausnehmung, die die Form eines Reflektors des optoelektronischen Bauteils bestimmen kann, kann die Abstrahl- und/oder Empfangscharakteristik des optoelektronischen Bauteils vorteilhaft beeinflusst werden. Der Reflektor beziehungsweise die Wand der Ausnehmung können in den verschiedensten Formen ausgebildet sein. Die Ausnehmung kann beispielsweise die Form eines Paraboloids, einer Kugel, eines Kegels, eines Hyperboloids, eines Ellipsoids oder eines Segments aus mindestens einem dieser Körper aufweisen.

Die Aussparung des Reflektorkörpers ist besonders bevorzugt entsprechend der Ausnehmung des Gehäusekörpers und somit entsprechend der Form des Reflektors ausgebildet, so dass das Reflektorteil nach der Vorformung in einfacher Weise auf das Grundteil aufgesetzt werden kann. Weitere Bearbeitungsschritte zur Ausbildung der geeigneten Form der Ausnehmung des Gehäusekörpers können so vorteilhaft vermieden werden.

Bevorzugt ist das Reflektormaterial elektrisch vom Anschlussleitermaterial isoliert. Die Gefahr eines Kurzschlusses der Anschlussleiter über das Reflektormaterial wird dadurch mit Vorteil verringert.

Die elektrische Isolation des Reflektormaterials vom Anschlussleitermaterial kann beispielsweise durch ein Isolationsteil geschehen, das der Gehäusekörper gemäß einer weiteren bevorzugten Ausgestaltung umfasst. Besonders bevorzugt ist dieses Isolationsteil zwischen dem Grund- und dem Reflektorteil derart angeordnet, dass das Reflektormaterial des Reflektorteils nicht in leitenden Kontakt mit dem Anschlussleitermaterial des Grundteils tritt.

Das Isolationsteil ist vorzugsweise getrennt von dem Grundteil und dem Reflektorteil vorgeformt und enthält besonders bevorzugt ebenfalls eine Keramik.

Auch kann in dem Isolationsteil eine Aussparung vorgesehen sein, die entsprechend der Ausnehmung im Gehäusekörper ausgebildet sein kann.

Weiterhin ist auf dem Grundteil ein Haftvermittlungsteil angeordnet, das vorzugsweise vom Halbleiterchip aus gesehen dem Reflektorteil nachgeordnet ist.

Das Haftvermittlungsteil weist weiterhin eine Aussparung auf, die entsprechend der Ausnehmung des Gehäusekörpers ausgebildet sein kann.

Das Haftvermittlungsteil ist weiterhin so ausgebildet oder geformt, dass eine Umhüllung beziehungsweise das Material der Umhüllung, das zum Schutz des Halbleiterchips vor schädlichen äußeren Einflüssen in der Ausnehmung angeordnet sein kann, am Haftvermittlungsteil besser haftet als an dem Reflektormaterial. Die Gefahr einer Delamination der Umhüllung wird dadurch zumindest verringert.

Das Haftvermittlungsteil enthält eine Keramik. Besonders bevorzugt enthält das Umhüllungsmaterial ein Reaktionsharz, wie ein Acryl-, Epoxid-, oder Silikonharz, eine Mischung dieser Harze und/oder ein Silikon.

Silikon beispielsweise kann sich durch vorteilhaft hohe Beständigkeit gegenüber ultravioletter Strahlung und hohen Temperaturen, wie zum Beispiel Temperaturen bis 200° C, auszeichnen. Der Alterungsprozess, dem die Umhüllung bei Strahlungseinwirkung oder Temperaturschwankungen unterliegt, kann dadurch mit Vorteil verlangsamt werden, so dass die Effizienz und/oder die Lebensdauer des Bauteils in der Folge erhöht wird.

Die verschiedenen, insbesondere getrennt voneinander vorgeformten, Gehäusekörperteile, wie das Haftvermittlungsteil, das Isolationsteil, das Reflektorteil bzw. der Reflektorkörper und das Grundteil bzw. der Anschlusskörper können jeweils in einem entsprechenden Verbindungsbereich der weiter oben genannten Art, der etwa mittels Sinterverbindungen gebildet ist, dauerhaft mechanisch stabil zusammengefügt sein.

Weitere Merkmale, Vorteile und Zweckmäßigkeiten der Erfindung ergeben sich aus der nachfolgenden Beschreibung der Ausführungsbeispiele in Zusammenhang mit den Figuren.

Es zeigen:
- Figur 1: ein erstes Ausführungsbeispiel eines erfindungsgemäßen optoelektronischen Bauteils anhand einer schematischen Aufsicht von oben in Figur 1A, einer schematischen Schnittansicht in Figur 1B, einer Aufsicht auf ein Grundteil von oben in Figur 1C, einer Aufsicht auf ein Grundteil von unten in Figur 1D sowie einer Aufsicht auf ein Reflektorteil von oben in Figur 1E,
- Figur 2: ein zweites Ausführungsbeispiel eines erfindungsgemäßen optoelektronischen Bauteils anhand einer schematischen Schnittansicht und
- Figur 3: ein drittes Ausführungsbeispiel eines erfindungsgemäßen optoelektronischen Bauteils anhand einer schematischen Schnittansicht in Figur 3A und einer schematischen Aufsicht auf das Grundteil von unten in Figur 3B.

Gleichartige oder gleich wirkende Elemente sind in den Figuren mit entsprechenden Bezugszeichen versehen.

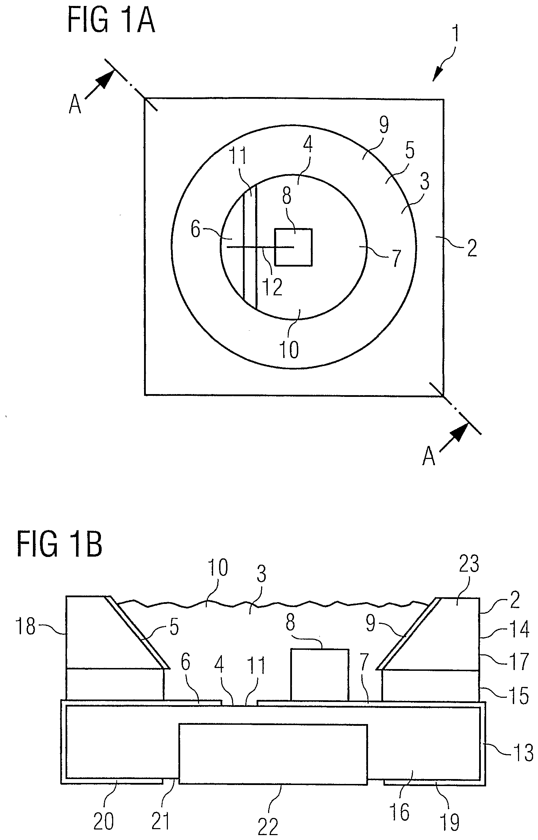

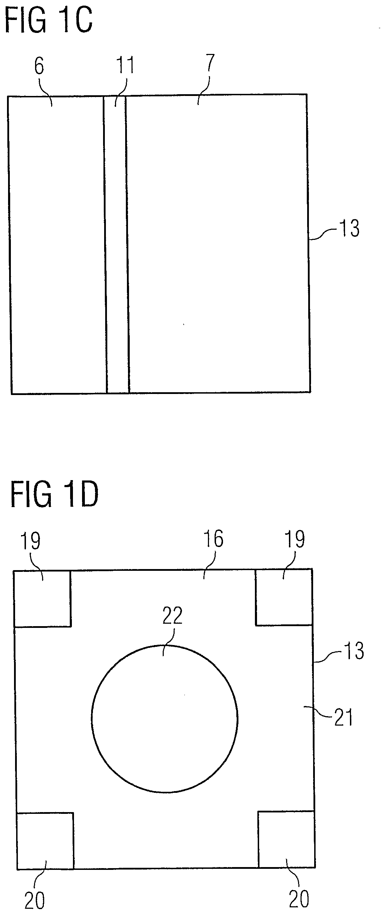

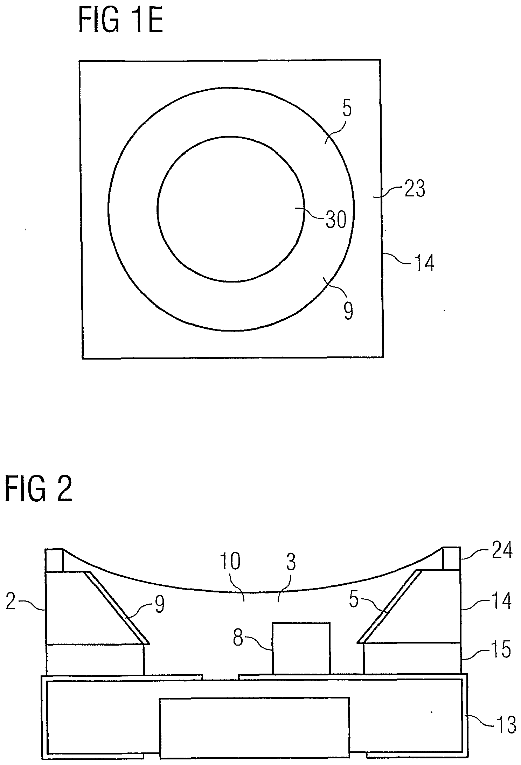

In der Figur 1 ist ein erstes Ausführungsbeispiel eines erfindungsgemäßen optoelektronischen Bauteils anhand verschiedener Ansichten und Ansichten von Teilen eines Gehäusekörpers des optoelektronischen Bauteils anhand der Figuren 1A, 1B, 1C, 1D und 1E dargestellt.

Figur 1A zeigt eine schematische Aufsicht auf ein erfindungsgemäßes optoelektronisches Bauteil 1. Der Gehäusekörper 2 des optoelektronischen Bauteils weist eine Ausnehmung 3 mit einem Boden 4 und einer Wand 5 auf. Auf dem Boden der Ausnehmung sind zwei elektrisch voneinander getrennte oder isolierte Anschlussleiterbereiche 6 und 7 ausgebildet.

Vorzugsweise enthalten die Anschlussleiterbereiche im wesentlichen Au. Auf dem Anschlussleiterbereich 7 ist ein optoelektronischer Halbleiterchip 8 angeordnet und vorzugsweise elektrisch leitend mit dem Anschlussleiterbereich 7 verbunden. Die leitende Verbindung kann beispielsweise über eine Lotverbindung oder einen elektrisch leitend ausgebildeten Klebstoff erfolgen. Wegen der in der Regel höheren thermischen und elektrischen Belastbarkeit ist eine Lotverbindung jedoch bevorzugt. Mit dem zweiten Anschlussleiterbereich 6 ist der optoelektronische Halbleiterchip 8 über einen Bonddraht 12 elektrisch leitend verbunden.

Insbesondere für die Ausbildung einer Lot- oder einer Bondverbindung des Halbleiterchips mit den Anschlussleiterbereichen ist Au aufgrund seiner vorteilhaften Materialeigenschaften gut geeignet, weshalb die Anschlussleiterbereiche mit Vorzug zumindest auf der dem Halbleiterchip zugewandten Oberfläche im wesentlichen aus Au bestehen. In Richtung des Anschlusskörpers können die Anschlussleiterbereiche noch andere Metalle oder Metallschichten, beispielsweise Ni gefolgt von W, enthalten wobei die Ni-haltige Schicht mit Vorzug zwischen der W-haltigen Schicht und dem Halbleiterchip angeordnet ist. Die Ausbildung der Anschlussleiterbereiche über chemische und/oder galvanische Prozesse kann so vorteilhaft erleichtert werden, wobei die W-haltige Schicht, die Anschlussleiterstruktur bestimmt und diese Struktur durch die Ni-haltige Schicht verstärkt wird, wonach Au aufgebracht werden kann. Anstelle von Au kann auch eine NiPd Legierung vorgesehen werden, die hinsichtlich der Ausbildung einer Lot- oder Bondverbindung ähnlich vorteilhafte Eigenschaften wie Au aufweist.

Die Anschlussleiterbereiche 6 und 7 sind durch einen Isolierspalt 11 im Anschlussleitermaterial elektrisch voneinander getrennt oder isoliert.

Der Halbleiterchip kann dabei als strahlungsemittierenden oder strahlungsempfangender Halbleiterchip, wie als LED-Chip oder als Photodioden-Chip ausgebildet sein und basiert beispielsweise auf den Materialsystemen InₓGa_{y}Al_{1-x-y}P oder InₓGa_{y}Al_{1-x-y}N, die für ultraviolette bis grüne Strahlung beziehungsweise für gelbgrüne bis infrarote Strahlung geeignet sind. Der Halbleiterchip kann auch als Sibasierender Photodiodenchip ausgebildet sein.

Die Wand 5 der Ausnehmung ist mit einem Reflektormaterial versehen, beispielsweise im wesentlichen Ag enthaltend. Die Wand 5 bildet zusammen mit dem auf ihr angeordneten Reflektormaterial einen Reflektor 9 für die vom optoelektronischen Halbleiterchip zu empfangende oder zu erzeugende Strahlung. Ag zeichnet sich hierbei durch eine vorteilhaft hohe Reflektivität über einen hohen Wellenlängenbereich, insbesondere auch im blauen und ultravioletten Wellenlängenbereich, aus.

Das Reflektormaterial ist bevorzugt vom Anschlussleitermaterial verschieden. In diesem Ausführungsbeispiel enthält das Anschlussleitermaterial im wesentlichen Au und das Reflektormaterial Ag. Eine nachteilige Migration von Ag-Atomen aus dem Anschlussleitermaterial in den Halbleiterchip, die zu einer Schädigung des Halbleiterchips führen können kann so ebenso vermieden werden wie eine im Falle von Au als Reflektormaterial relativ geringe Reflektivität im ultravioletten oder blauen Spektralbereich. Die hohe Reflektivität von Ag im ultravioletten Spektralbereich führt auch dazu, dass das Material des Gehäusekörpers, der beispielsweise im wesentlichen eine Keramik enthält, zumindest im Bereich des Reflektormaterials wirksam vor UV-Strahlung geschützt werden kann. Die Gefahr von schädlichen Alterungserscheinungen des Gehäusekörpers kann so zumindest verringert werden.

In der Ausnehmung 3 des Gehäusekörpers 2 ist eine Umhüllung 10 angeordnet, die den optoelektronischen Halbleiterchip mit Vorteil vor schädlichen äußeren Einflüssen, wie beispielsweise Feuchtigkeit, schützt. Die Umhüllung 10 enthält beispielsweise Silikon, das sich durch eine hohe Temperaturbeständigkeit und Beständigkeit gegenüber etwa durch UV-Strahlung verursachten nachteiligen Verfärbungen auszeichnet.

Die Umhüllung umformt den Halbleiterchip vorzugsweise zumindest teilweise, um den Schutz des Halbleiterchips weitergehend zu verbessern. Die Effizienz des optoelektronischen Bauteils kann dadurch mit Vorteil gesteigert werden.

Es sei angemerkt, dass die Ausnehmung in Aufsicht auch eine von der dargestellten im wesentlichen kreisförmigen Form abweichende Form besitzen kann. Die Formgebung der Ausnehmung und insbesondere des Reflektors, welche die Abstrahl- oder Empfangscharakteristik des optoelektronischen Bauteils bestimmt, kann in verschiedenen, für diverse Anwendungen geeigneten Formen, ausgebildet werden.

In der Figur 1B ist schematisch eine Schnittansicht entlang der Linie A-A durch das optoelektronische Bauteil gemäß Figur 1A dargestellt.

In dieser Schnittdarstellung ist der mehrschichtige beziehungsweise mehrteilige Aufbau des Gehäusekörpers 2 aus Figur 1A deutlich zu erkennen. Dem Grundteil 13 des Gehäusekörpers 2 ist über ein Isolationsteil 15 ein Reflektorteil 14 nachgeordnet. Die Teile des Gehäusekörpers sind dabei bevorzugt getrennt voneinander vorgeformt. Zumindest das Reflektorteil und das Grundteil sind zumindest teilweise getrennt voneinander vorgeformt.

Das Grundteil umfasst einen Anschlusskörper 16, der vorzugsweise eine Keramik enthält. An dem Anschlusskörper sind die Anschlussleiterbereiche 6 und 7, die durch den Isolierspalt 11 in zwei elektrisch voneinander getrennte Bereiche getrennt werden, angeordnet. Die Anschlussleiterbereiche verlaufen vom Halbleiterchip 8 ausgehend in lateraler Richtung nach außen bis an die Seitenflächen 17 und 18 des Gehäusekörpers 2. Im Bereich der Seitenflächen sind die Anschlussleiterbereiche mit Anschlüssen 19 und 20 auf der dem Halbleiterchip abgewandten Oberfläche 21 des Gehäusekörpers leitend verbunden. Die Anschlüsse 20 und 19 können mit Vorteil ebenso wie die Anschlussleiterbereiche 6 und 7 bereits während der Vorformung des Grundteils 13 des Gehäusekörpers ausgebildet werden. Beispielsweise enthalten die Anschlüsse 19 und 20 ebenfalls ein Metall, wie Au. Bevorzugt sind die Anschlüsse 19 und 20 und die Anschlussleiterbereiche 6 und 7 aus im wesentlichen dem gleichen Material oder in einander entsprechender Weise ausgebildet. Die Vorformung eines Grundteils mit den Anschlüssen 19 und 20 kann so vorteilhaft erleichtert werden.

Über die Anschlüsse 19 und 20 kann das optoelektronische Bauteil mit den Leiterbahnen einer Leiterplatte, beispielsweise einer Metallkernplatine (z.B. ein Metallkern-PCB, PCB: Printed Circuit Board), elektrisch leitend verbunden werden. Das optoelektronische Bauteil ist vorzugsweise oberflächenmontierbar ausgebildet. Anschlüsse 19 und 20, die im wesentlichen Au enthalten, zeichnen sich im Vergleich zu Ag enthaltenden Anschlüssen durch geringere Oxidationstendenz aus. Ag oxidiert gewöhnlich schneller als Au, was sich insbesondere bei langen Lagerzeiten der Bauteile nachteilig, beispielsweise auf die Lötbarkeit, von Agenthaltenden Anschlüssen auswirken kann.

Der Halbleiterchip kann upside-up oder upside-down auf dem Anschlussleiterbereich 7 angeordnet werden. Upside-up bedeutet hierbei, dass ein Substrat oder Träger zwischen der aktiven Zone und dem Anschlußbereich angeordnet ist, während die aktive Zone des Halbleiterchips bei einer upside-down Anordnung zwischen Substrat und Anschlussleiterbereich angeordnet ist. Da Au-Atome gewöhnlich verglichen mit Ag-Atomen wesentlich geringere Migrationstendenzen in den Halbleiterchip zeigen, wird die Gefahr einer Schädigung des Halbleiterchips durch einmigrierende Atome aufgrund der Verwendung von Materialien mit vergleichsweise geringen Migrationstendenzen, wie Au, vorteilhaft verringert. Insbesondere bei einer upside-down Anordnung ohne ein schützendes Substrat oder einen Träger zwischen der aktiven Zone und dem Anschlussleitermaterial ist dies von Vorteil.

Vorzugsweise ist die Keramik, die der Anschlusskörper enthalten kann, eine Aluminiumnitrid- oder AluminiumoxidKeramik. Beide Keramiken zeichnen sich durch vorteilhaft hohe Wärmeleitfähigkeiten aus, wobei die Wärmeleitfähigkeit des Aluminiumnitrids meist noch etwas höher ist als die des Aluminiumoxids. Allerdings ist Aluminiumnitrid gewöhnlich in der Anschaffung kostenintensiver als Aluminiumoxid.

Der Anschlusskörper 16 umformt bevorzugt zumindest teilweise eine Wärmesenke 22. Die Wärmesenke enthält mit Vorzug ein Metall, beispielsweise Au, Ag, Cu und/oder W. Derartige Metalle zeichnen sich durch eine vorteilhaft hohe Wärmeleitfähigkeit aus. W beispielsweise ist auch bezüglich der thermischen Ausdehnung gut an die genannten Keramiken, insbesondere an AlN, angepasst, wodurch die Stabilität des Gehäusekörpers weitergehend vorteilhaft erhöht wird. Das material der Wärmesenke kann vom Material der Anschlussleiter verschieden sein und entsprechend seiner vorteilhaften Eigenschaften im Rahmen der Fertigungsmöglichkeiten mit Vorteil im wesentlichen frei gewählt werden.

Die an sich schon relativ hohe Wärmeleitfähigkeit eines Anschlusskörpers, der eine der oben genannten Keramiken enthält, kann mit Vorteil durch die Wärmesenke noch gesteigert werden. Die Wärmesenke ist vorzugsweise in dem Bereich des Anschlusskörpers angeordnet, der unter dem Halbleiterchip liegt. Somit kann während des Befestigen des Halbleiterchips 8 auf dem Anschlussleiterbereich 7 über eine Lötverbindung, während deren Herstellung gewöhnlich hohe Temperaturen auftreten, die Wärmeableitung aus diesem Bereich vorteilhaft verbessert werden. Dadurch kann die Gefahr einer Delamination des Isolationskörpers und/oder der Anschlüsse von Anschlusskörper durch Temperaturschwankungen oder hohe Temperaturen verringert werden.

Die Wärmesenke ist weiterhin bevorzugt vom Anschlussleitermaterial in Form der Anschlussleiterbereiche 6 und 7 elektrisch isoliert. Dies kann beispielsweise über einen Bereich des Material des Anschlusskörpers erfolgen der zwischen dem Anschlussleitermaterial und der Wärmesenke angeordnet ist. Die elektrische Isolation vermeidet mit Vorteil einen Kurzschluss der elektrisch voneinander getrennten Anschlussleiterbereiche und ermöglicht zugleich eine großflächige Ausbildung der Wärmesenke. Die Ausbildung der Wärmesenke erfolgt mit Vorteil ebenfalls bereits während der Vorformung des Grundteils oder des Anschlusskörpers.

Mit Vorzug ist die Wärmesenke so ausgebildet, dass sie seitens der Oberfläche 21 des Grundteils in einem Maße aus dem Anschlusskörper 16 herausragt, die den Anschlüssen 19 und 20 entspricht. Bei einer Anordnung des optoelektronischen Bauteils auf einer Leiterplatte kann dadurch die thermisch leitende Verbindung dieser Wärmesenke 22 zu einem externen Kühlkörper, wie beispielsweise dem Metallkern einer Metallkernplatine erleichtert werden. Weiterhin kann sich diese Ausgestaltung der Wärmesenke mechanisch stabilisierend auf die Anordnung des optoelektronischen Bauteils auf einer Leiterplatte auswirken.

Ein derartiges vorgeformtes Grundteil 13 mit Anschlussleiterbereichen 6, 7 Anschlüssen 19, 20 und einer Wärmesenke 22, dessen Anschlusskörper 16 eine Keramik mit hoher Wärmeleitfähigkeit aufweist, kann für ein optoelektronisches Bauteil von erheblichem Vorteil sein. Die zum Wärmeabtransport vom Halbleiterchip 8 zur Verfügung stehende Fläche wird durch die Keramik und die Wärmesenke verglichen mit einer herkömmlichen Premolded-Gehäusebauform stark vergrößert. Insbesondere die Wärmesenke verkürzt den Transportweg der am Halbleiterchip, beispielsweise durch den Lötprozess des Halbleiterchips auf den Anschlussleiterbereich oder im Betrieb des Bauteils, entstehenden Wärme zur Wärmesenke.

Das Grundteil 13 bestimmt in der Darstellung des Ausführungsbeispiels in Figur 1B den Boden 4 der Ausnehmung 3 des Gehäusekörpers 2.

Abweichend von der Darstellung in Figur 1B kann auch auf die Wärmesenke verzichtet werden, insbesondere, falls der Anschlusskörper im wesentlichen eine Keramik, wie AlN, enthält, die eine besonders vorteilhaft hohe Wärmeleitfähigkeit aufweist. Vorzugsweise ist in diesem Falle auf der Oberfläche des Gehäusekörpers im Bereich der in Figur 1B gezeigten Wärmesenke ein, beispielsweise ein Metall, wie eines der weiter oben genannten Metalle, enthaltender, thermischer Anschluss zum Anschluss an einen externen Kühlkörper vorgesehen, der besonders bevorzugt von den Anschlüssen 19 und 20 elektrisch isoliert ist.

In der Figur 1C ist eine Aufsicht von oben auf ein Ausführungsbeispiel eines vorgeformten Grundteils entsprechend der Figur 1A oder 1B dargestellt. Es sind die Anschlussleiterbereiche 6 und 7, die durch den Isolierspalt 11 elektrisch getrennt sind, dargestellt. Der Halbleiterchip wird erst nach dem Verbinden der getrennt vorgeformten Gehäuseteile auf dem Anschlussleiterbereich 7 angeordnet.

Figur 1D zeigt eine Aufsicht von unten auf ein Ausführungsbeispiel eines Grundteils 13, wie es beispielsweise in der in Figur 1A oder 1B gezeigten Ansicht dargestellt ist. Zu erkennen sind die Anschlüsse 19 und 20, die der elektrischen Kontaktierung des Halbleiterchips seitens der Oberfläche 21 des Grundteils 13 dienen. Ferner ist die vom Anschlusskörper 16 zumindest teilweise umformte Wärmesenke 22 dargestellt.

Es sei angemerkt, dass die Anschlüsse insbesondere hinsichtlich ihrer Anzahl und konkreten Ausbildung in der Figur 1D nur beispielhaft vier im wesentlichen rechteckige Anschlüsse - zwei für jeden Anschluss des Halbleiterchips - dargestellt sind. Auch die Wärmesenke ist lediglich beispielhaft als in Aufsicht kreisförmig dargestellt. Dies ist selbstverständlich nicht als Beschränkung auf eine derartige Ausbildung zu verstehen. Zweckmäßigerweise ist die Wärmesenke von den Anschlüssen isoliert, insbesondere mittels einer zu den Anschlüssen lateral beabstandeten Anordnung, so dass die Gefahr eines Kurzschlusses der Anschlüsse über die Wärmesenke verringert wird.

Das Reflektorteil 14 ist in diesem Ausführungsbeispiel getrennt vom Grundteil 13 vorgeformt und enthält vorzugsweise eine Keramik, beispielsweise Aluminiumnitrid oder Aluminiumoxid. Eine Aufsicht auf ein vorgeformtes Reflektorteil ist in Figur 1E gezeigt. Das Reflektorteil 14 umfasst einen Reflektorkörper 23, der mit einer Aussparung 30 versehen ist, die durch den gesamten Reflektorkörper 23 reicht. Die Aussparung 30 ist Teil der Ausnehmung 3 des fertigen Gehäusekörpers 2. Die Aussparung 30 weist eine Wand 5 auf, die vorzugsweise während des Vorformens mit einem Reflektormaterial, beispielsweise Ag enthaltend, versehen wurde. Die Form der Wand beziehungsweise die Form der Aussparung bestimmen die Form des Reflektors 9, der durch die Wand 5 der Aussparung und das auf der Wand angeordnete Reflektormaterial gebildet wird. Die Wand 5 der Aussparung 30 ist bevorzugt zumindest annähernd vollflächig mit dem Reflektormaterial bedeckt, so dass die Reflektorfläche für eine vom Halbleiterchip zu erzeugende oder zu empfangende Strahlung möglichst groß ist.

Wie in Figur 1B gezeigt ist, ist das Reflektorteil 14 im Gehäusekörper 2 dem Grundteil nachgeordnet. Um einen Kurzschluss der Anschlussleiterbereiche 6 und 7 über das Reflektormaterial zu vermeiden, ist der Reflektor 9 beziehungsweise das Reflektormaterial durch ein Isolationsteil 15 elektrisch von den Anschlussleiterbereichen 6 und 7 isoliert. Das Isolationsteil enthält bevorzugt eine Keramik, beispielsweise ebenfalls Aluminiumnitrid oder Aluminiumoxid, was Vorteile beim Verbinden der einzeln vorgeformten Teile des Gehäusekörpers haben kann. Bezüglich der Formgebung wird beim Isolationsteil bevorzugt darauf geachtet, dass das Isolationsteil möglichst genau mit der seitens des Grundteils angeordneten Begrenzung der Aussparung im Reflektorteil abschließt. Zumindest ist das Isolationsteil mit Vorzug in lateraler Richtung nicht näher am Halbleiterchip angeordnet als das Reflektorteil. Mit Vorteil wird so die reflektierende Fläche nicht verkleinert, da auch das Anschlussleitermaterial, welches beispielsweise Au enthält, abhängig von der Wellenlänge der einfallenden Strahlung relativ hohe Reflektivitäten aufweisen kann.

Die Umhüllung 10 umhüllt wie in Figur 1B dargestellt den Halbleiterchip 8 zumindest teilweise und schützt ihn vor schädlichen äußeren Einflüssen. Weiterhin ist die Umhüllung im Bereich der Aussparung des Reflektorkörpers 23 an dem Reflektormaterial angeordnet und seitens des Grundteils 13 zumindest teilweise am Anschlussleitermaterial angeordnet. Diese können wie oben bereits erwähnt Metalle enthalten, an denen das beispielsweise Silikon enthaltende Umhüllungsmaterial oftmals nur relativ schlecht haftet.

In der Figur 2 ist ein zweites Ausführungsbeispiel eines erfindungsgemäßen optoelektronischen Bauteils schematisch anhand einer Schnittansicht dargestellt. Das dargestellte Ausführungsbeispiel entspricht im wesentlichen dem in Figur 1 gezeigten Ausführungsbeispiel. Im Unterschied zu diesem ist dem Reflektorteil 14 vom Halbleiterchip 8 aus gesehen, der auf dem Grundteil 13 angeordnet ist, ein Haftvermittlungsteil 24 angeordnet. Das Haftvermittlungsteil 24 ist vorzugsweise so ausgebildet oder geformt, dass es die Haftung der Umhüllung 10 in der Ausnehmung 3 des Gehäusekörpers 2 verbessert. Das Haftvermittlungsteil enthält bevorzugt eine Keramik, beispielsweise ebenfalls Aluminiumnitrid oder Aluminiumoxid. Silikon, das das Umhüllungsmaterial beispielsweise enthält, haftet an einem derartigen Keramikmaterial gewöhnlich besser als an einem Metall, wie das Reflektormaterial, das auf der Wand 5 der Ausnehmung des Gehäusekörpers, oder das Anschlussleitermaterial, das auf dem Grundteil angeordnet ist. Die Gefahr schädigender äußerer Einflüsse auf den Halbleiterchip wird durch verbesserte Haftung der Umhüllung in der Ausnehmung mit Vorteil verringert. Die haftvermittelnde Fläche kann durch eine Abstufung zwischen Reflektorteil und Haftvermittlungsteil vorteilhaft vergrößert werden. Hierzu ist das Reflektorteil bevorzugt auf seiner dem Boden 4 der Ausnehmung 3 gegenüberliegenden Fläche im wesentlichen frei von dem Reflektormaterial.

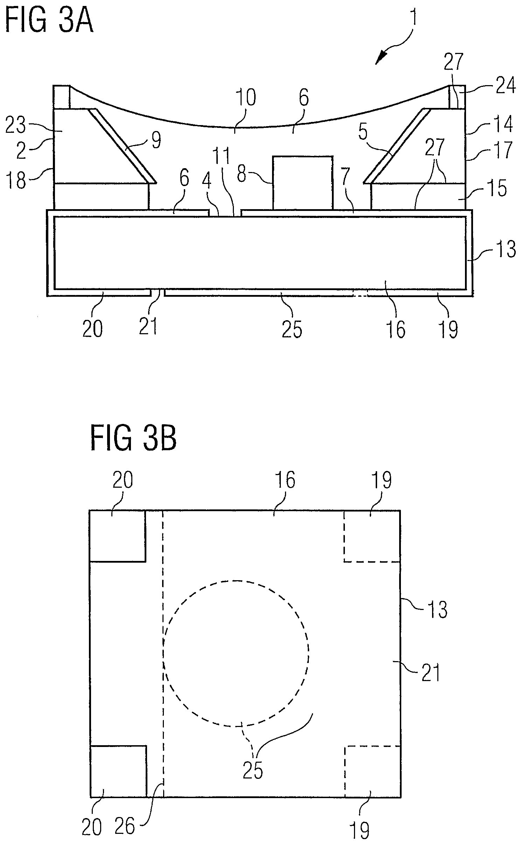

Figur 3 zeigt anhand einer schematischen Schnittansicht in Figur 3A und einer schematischen Aufsicht von unten auf das Grundteil in Figur 3B ein drittes Ausführungsbeispiel eines erfindungsgemäßen optoelektronischen Bauteils.

Im wesentlichen entspricht das in Figur 3 gezeigte Ausführungsbeispiel dem in Figur 2. Im Unterschied hierzu ist beim optoelektronischen Bauteil gemäß Figur 3 auf eine zusätzliche Wärmesenke verzichtet. Der Halbleiterchip 8 ist mittels des seitens der dem Halbleiterchip gegenüber liegenden Oberfläche 21 des Gehäusekörpers 2 angeordneten thermischen Anschluss 25 thermisch anschließbar. Über den thermischen Anschluss 25 kann der Halbleiterchip mit einem externen Kühlkörper thermisch leitend verbunden werden.

Die Wärmeableitung vom Halbleiterchip erfolgt hierbei im wesentlichen durch das Material des Anschlusskörpers 16, der hierzu zweckmäßigerweise eine Keramik hoher Wärmeleitfähigkeit enthält. Bevorzugt enthalten die Gehäuseteile des Gehäusekörpers 2, wie das Haftvermittlungsteil 24, das Reflektorteil 14 beziehungsweise der Reflektorkörper 23, das Isolationsteil 15 und/oder das Grundteil 13 beziehungsweise der Anschlusskörper 16 eine Keramik. Aufgrund der besonders hohen Wärmeleitfähigkeit ist eine Aluminiumnitrid-Keramik besonders geeignet.

Bevorzugt sind der thermische Anschluss 25 und der Anschluss 19 und/oder der Anschluss 20 aus dem (den) gleichen Material(ien) gefertigt. Der thermische Anschluss kann so vereinfacht bei der Vorformung des Grundteils zusammen mit den Anschlussleiterbereichen 6 und 7 und/oder den Anschlüssen 19 und 20 ausgebildet werden.

Der thermische Anschluss 25 kann von den Anschlüssen 19 und 20, die auf der Oberfläche 21 des Gehäusekörpers, angeordnet sind, elektrisch getrennt sein. Dies ist in der Aufsicht auf die Oberfläche 21 des Gehäusekörpers in Figur 3B durch die gestrichelte Linie bei Bezugszeichen 25 gekennzeichnet, das den thermischen Anschluss bezeichnet, der durch die unterbrochene Kreislinie dargestellt ist und von dem Anschluss 20 sowie dem gestrichelt dargestellten Anschluss 19 elektrisch isoliert ist.

Alternativ kann der thermische Anschluss 25 mit einem der beiden Anschlussleiter elektrisch leitend verbunden sein. Dies ist in Figur 3A durch die gestrichelte Linie zwischen dem thermischen Anschluss 25 und dem Anschluss 19 angedeutet. Die gestrichelte Linie 26 in Figur 3B kennzeichnet einen thermischen Anschluss 25, der zusammen mit dem Anschluss 19 einstückig realisiert, dementsprechend leitend mit dem Anschluss 19 verbunden ist und elektrisch vom Anschluss 20 isoliert ist. Ein Kurzschluss der Anschlüsse 19 und 20 über den thermischen Anschluss wird so vermieden. Die durchgezogene Linienführung bei Bezugszeichen 25 kennzeichnet einen derartigen thermischen Anschluss. Hierdurch wird ein großflächiger thermischer Anschluss des Halbleiterchips seitens der Oberfläche 21 erleichtert, ohne die Baugröße des Gehäusekörpers zu erhöhen.

Die verschiedenen Gehäusekörperteile des Gehäusekörpers 2-des optoelektronischen Bauelements 1 sind bevorzugt mittels mechanisch stabiler Verbindungsbereiche 27 verbunden. Besonders bevorzugt ist ein derartiger Verbindungsbereich zwischen je zwei benachbart angeordneten oder aneinandergrenzenden Gehäusekörperteilen ausgebildet.

In der Folge weist der Gehäusekörper des optoelektronischen Bauteils eine vorteilhaft hohe Gesamtstabilität auf.

Die Verbindungsbereiche können insbesondere durch Sinterverbindungen gebildet sein, die beim Zusammensintern der geeignet übereinander gelegten einzelnen Gehäusekörperteile ausgebildet werden können.

Derartige Verbindungsbereiche 27 können selbstverständlich auch bei den Ausführungsbeispielen gemäß Figur 1 oder 2 vorgesehen sein.

Den Ausführungsbeispielen in Figur 1, Figur 2 und Figur 3 ist gemein, dass der Reflektor 9 in der Schnittansicht eine im wesentlichen kegelstumpfförmige Form aufweist. Während der Vorformung des Reflektorteils 14 können jedoch verschiedenste Formen der Wand 5 der Ausnehmung 3 beziehungsweise der Aussparung 30 im Reflektorkörper realisiert werden. Je nach Ausgestaltung der Form des Reflektors weist das optoelektronische Bauteil verschiedene Empfangs- oder Abstrahlcharakteristiken aus. Ist der Reflektorteil eines Körper, der einen Fokus oder Fokalbereich aufweist, so ist der Halbleiterchip 8 bevorzugt in diesem Fokus oder diesem Fokalbereich angeordnet. Beispielsweise kann die Ausnehmung auch abweichend von der Darstellung als im wesentlich einen parabolischen Querschnitt aufweisend ausgeführt werden.

Ebenfalls sind in den Ausführungsbeispielen die verschiedenen Gehäuseteile wie das Grundteil, das Isolationsteil, das Reflektorteil oder das Haftvermittlungsteil 24 vorzugsweise getrennt voneinander vorgeformt. Nach deren Vorformung werden die Teile entsprechend übereinander angeordnet, so dass beispielsweise die in Figur 1B, in Figur 2 oder Figur 3A anhand einer Schnittdarstellung gezeigte Struktur ausgebildet wird. Nach der Anordnung der vorgeformten Teile des Gehäusekörpers 2 übereinander wird diese Struktur, beispielsweise mittels eines Sinterprozesses, derart mechanisch stabil verbunden, dass an den Grenzflächen zwischen den verschiedenen Gehäuseteilen, insbesondere jeweils, ein Verbindungsbereich, etwa eine mechanisch stabile Sinterverbindung, ausgebildet wird. Die verschiedenen Teile des Gehäusekörpers sind mittels der Verbindungsbereiche dauerhaft mechanisch stabil verbunden. Ein derartiger Gehäusekörper weist eine vorteilhaft hohe mechanische Stabilität auf und ist aufgrund der getrennten Vorformung der einzelnen Teile variabel ausbildbar, wobei die Wärmeableitungseigenschaften des Gehäusekörpers im Falle eines für die Einzelteile verwendeten Keramikmaterials vorteilhaft hoch ist.

Weiterhin kann bei den Ausführungsbeispielen in die Umhüllung ein Leuchtstoff eingebracht werden. Der Leuchtstoff ist bevorzugt so ausgebildet, dass er vom Halbleiterchip emittierte Strahlung absorbieren kann und diese als Strahlung einer Wellenlänge, die größer ist als der vom Halbleiterchip emittierten Strahlung ist. Die Wellenlängen können sich mischen so dass das optoelektronische Bauteil mischfarbiges, insbesondere weißes Licht, emittieren kann.

Diese Patentanmeldung beansprucht die Priorität der deutschen Patentanmeldung 10 2004 014207.6 vom 23. März 2004. Die Erfindung ist nicht durch die Beschreibung der Erfindung anhand der Ausführungsbeispiele beschränkt.

## Patentansprüche

1. Optoelektronisches Bauteil (1) mit einem Gehäusekörper (2) und mindestens einem auf dem Gehäusekörper angeordneten Halbleiterchip (8), wobei der Gehäusekörper ein Grundteil (13), das einen Anschlusskörper (16) umfasst, auf dem ein Anschlussleitermaterial (6,7) angeordnet ist, und ein Reflektorteil (14) aufweist, das einen Reflektorkörper (23) umfasst, auf dem ein Reflektormaterial (9) angeordnet ist, wobei
der Anschlusskörper und der Reflektorkörper getrennt voneinander vorgeformt sind, wobei
der Reflektorkörper in Form eines Reflektoraufsatzes auf dem Anschlusskörper angeordnet ist, und wobei
der Gehäusekörper eine Ausnehmung (3) aufweist, in der der Halbleiterchip angeordnet ist, in der Ausnehmung des Gehäusekörpers eine Umhüllung (10) angeordnet ist, die den Halbleiterchip zumindest teilweise umhüllt,
**dadurch gekennzeichnet, dass**
auf dem Grundteil ein Haftvermittlungsteil (24) angeordnet ist, das eine Aussparung aufweist, die Teil der Ausnehmung des Gehäusekörpers ist,
das Haftvermittlungsteil eine Keramik enthält,
wobei die Umhüllung an dem Haftvermittlungsteil angeordnet ist und
die Umhüllung an dem Haftvermittlungsteil besser haftet als an dem Reflektormaterial.

2. Optoelektronisches Bauteil nach Anspruch 1,
**dadurch gekennzeichnet, dass**
das Grundteil und das Reflektorteil getrennt voneinander vorgeformt sind.

3. Optoelektronisches Bauteil nach Anspruch 1 oder 2,
**dadurch gekennzeichnet, dass**
der Anschlusskörper eine Keramik enthält.

4. Optoelektronisches Bauteil nach einem der vorhergehenden Ansprüche,
**dadurch gekennzeichnet, dass**
der Gehäusekörper Aluminiumnitrid oder Aluminiumoxid enthält.

5. Optoelektronisches Bauteil nach einem der vorhergehenden Ansprüche,
**dadurch gekennzeichnet, dass**
das Anschlussleitermaterial vom Reflektormaterial verschieden ist.

6. Optoelektronisches Bauteil nach einem der vorhergehenden Ansprüche,
**dadurch gekennzeichnet, dass**
das Anschlussleitermaterial ein Metall enthält.

7. Optoelektronisches Bauteil nach einem der vorhergehenden Ansprüche,
**dadurch gekennzeichnet, dass**
das Reflektormaterial ein Metall enthält.

8. Optoelektronisches Bauteil nach einem der vorhergehenden Ansprüche,
**dadurch gekennzeichnet, dass**
das Anschlussleitermaterial Au und das Reflektormaterial Ag enthält.

9. Optoelektronisches Bauteil nach einem der vorhergehenden Ansprüche,
**dadurch gekennzeichnet, dass**
der Reflektorkörper mit dem Reflektormaterial beschichtet ist.

10. Optoelektronisches Bauteil nach einem der vorhergehenden Ansprüche,
**dadurch gekennzeichnet, dass**
der Reflektorkörper eine Aussparung (30) aufweist, die Aussparung Teil der Ausnehmung des Gehäusekörpers ist und das Reflektormaterial auf einer Wand (5) der Aussparung angeordnet ist.

11. Optoelektronisches Bauteil nach einem der vorhergehenden Ansprüche,
**dadurch gekennzeichnet, dass**
das Reflektormaterial vom Anschlussleitermaterial elektrisch isoliert ist.

12. Optoelektronisches Bauteil nach einem der vorhergehenden Ansprüche,
**dadurch gekennzeichnet, dass**
zwischen dem Grundteil und dem Reflektorteil ein Isolationsteil (15) angeordnet ist.

13. Optoelektronisches Bauteil nach Anspruch 12,
**dadurch gekennzeichnet, dass**
das Isolationsteil getrennt von dem Grundteil und dem Reflektorteil vorgeformt ist.

14. Optoelektronisches Bauteil nach einem der vorhergehenden Ansprüche,
**dadurch gekennzeichnet, dass**
das Haftvermittlungsteil dem Reflektorteil nachfolgend auf dem Grundteil angeordnet ist.

15. Optoelektronisches Bauteil nach einem der vorhergehenden Ansprüche,
**dadurch gekennzeichnet, dass**
das Reflektorteil eine Keramik enthält.

16. Optoelektronisches Bauteil nach einem der vorhergehenden Ansprüche,
**dadurch gekennzeichnet, dass**
das Grundteil eine Wärmesenke (22) umfasst oder das optoelektronische Bauteil einen thermischen Anschluss aufweist.

17. Optoelektronisches Bauteil nach Anspruch 16,
**dadurch gekennzeichnet, dass**
die Wärmesenke elektrisch von dem Halbleiterchip isoliert ist.

18. Optoelektronisches Bauteil nach einem der vorhergehenden Ansprüche,
**dadurch gekennzeichnet, dass**
eine Wand der Ausnehmung mit dem Reflektormaterial beschichtet ist.

## Claims

1. An optoelectronic component (1) having a housing body (2) and at least one semiconductor chip (8) arranged on the housing body, wherein the housing body has a base part (13), comprising a connector body (16) on which a connecting conductor material (6,7) is arranged, and a reflector part (14), comprising a reflector body (23) on which a reflector material (9) is arranged, wherein the connector body and the reflector body are pre-formed separately from one another, wherein
the reflector body is arranged on the connector body in the form of a reflector attachment, and wherein
the housing body has a cavity (3) in which the semiconductor chip is arranged, in the cavity of the housing body a covering (10) is arranged, which at least partially covers the semiconductor chip,
**characterized in that**
on the base part an adhesion promoting part (24) is arranged, having a recess which is part of the cavity of the housing body,
the adhesion promoting part contains a ceramic,
wherein the covering is arranged on the adhesion promoting part and
the covering adheres better to the adhesion promoting part than to the reflector material.

2. The optoelectronic component according to claim 1,
**characterized in that**
the base part and the reflector part are pre-formed separately from each other.

3. The optoelectronic component according to claim 1 or claim 2,
**characterized in that**
the connector body contains a ceramic.

4. The optoelectronic component according to one of the preceding claims,
**characterized in that**
the housing body contains aluminum nitride or aluminum oxide.

5. The optoelectronic component according to one of the preceding claims,
**characterized in that**
the connecting conductor material is different from the reflector material.

6. The optoelectronic component according to one of the preceding claims,
**characterized in that**
the connecting conductor material contains a metal.

7. The optoelectronic component according to one of the preceding claims,
**characterized in that**
the reflector material contains a metal.

8. The optoelectronic component according to one of the preceding claims,
**characterized in that**
the connecting conductor material contains Au and the reflector material contains Ag.

9. The optoelectronic component according to one of the preceding claims,
**characterized in that**
the reflector body is coated with the reflector material.

10. The optoelectronic component according to one of the preceding claims,
**characterized in that**
the reflector body has a recess (30), which recess is part of the cavity of the housing body and the reflector material is arranged on a wall (5) of the recess.

11. The optoelectronic component according to one of the preceding claims,
**characterized in that**
the reflector material is electrically insulated from the connecting conductor material.

12. The optoelectronic component according to one of the preceding claims,
**characterized in that**
between the base part and the reflector part an insulation part (15) is arranged.

13. The optoelectronic component according to claim 12,
**characterized in that**
the insulation part is pre-formed separately from the base part and the reflector part.

14. The optoelectronic component according to one of the preceding claims,
**characterized in that**
the adhesion promoting part is arranged on the base part following the reflector part.

15. The optoelectronic component according to one of the preceding claims,
**characterized in that**
the reflector part contains a ceramic.

16. The optoelectronic component according to one of the preceding claims,
**characterized in that**
the base part comprises a heat sink (22) or the optoelectronic component has a thermal connection.

17. The optoelectronic component according to claim 16,
**characterized in that**
the heat sink is electrically insulated from the semiconductor chip.

18. The optoelectronic component according to one of the preceding claims,
**characterized in that**
a wall of the cavity is coated with the reflector material.

## Revendications

1. Composant optoélectronique (1) comprenant un corps de boîtier (2) et au moins une puce à semi-conducteur (8) disposée sur le corps de boîtier, le corps de boîtier présentant une partie de base (13), laquelle comprend un corps de raccordement (16), sur lequel est disposée une matière de conducteur de raccordement (6, 7), et présentant une partie de réflecteur (14) qui comprend un corps de réflecteur (23) sur lequel est disposée une matière réfléchissante (9),
le corps de raccordement et le corps de réflecteur étant préformés de manière séparée l'un de l'autre,
le corps de réflecteur étant disposé sur le corps de raccordement sous forme d'une pièce rapportée de réflecteur, et
le corps de boîtier présentant un évidement (3) dans lequel est disposée la puce à semi-conducteur, une enveloppe (10) étant disposée dans l'évidement du corps de boîtier,
laquelle enveloppe la puce à semi-conducteur au moins en partie,
**caractérisé en ce qu'**
une partie permettant l'adhérence (24) est disposée sur la partie de base, laquelle présente un renfoncement qui fait partie de l'évidement du corps de boîtier,
**en ce que** la partie permettant l'adhérence contient une céramique,
l'enveloppe étant disposée sur la partie permettant l'adhérence et
l'enveloppe adhérant mieux sur la partie permettant l'adhérence que sur la matière réfléchissante.

2. Composant optoélectronique selon la revendication 1,
**caractérisé en ce que**
la partie de base et la matière réfléchissante sont préformées de manière séparée l'une de l'autre.

3. Composant optoélectronique selon la revendication 1 ou 2,
**caractérisé en ce que**
le corps de base contient une céramique.

4. Composant optoélectronique selon l'une quelconque des revendications précédentes,
**caractérisé en ce que**
le corps de base contient du nitrure d'aluminium ou de l'oxyde d'aluminium.

5. Composant optoélectronique selon l'une quelconque des revendications précédentes,
**caractérisé en ce que**
la matière de conducteur de raccordement est différente de la matière réfléchissante.

6. Composant optoélectronique selon l'une quelconque des revendications précédentes,
**caractérisé en ce que**
la matière de conducteur de raccordement contient un métal.

7. Composant optoélectronique selon l'une quelconque des revendications précédentes,
**caractérisé en ce que**
la matière réfléchissante contient un métal.

8. Composant optoélectronique selon l'une quelconque des revendications précédentes,
**caractérisé en ce que**
la matière de conducteur de raccordement contient de l'Au et **en ce que** la matière réfléchissante contient de l'Ag.

9. Composant optoélectronique selon l'une quelconque des revendications précédentes,
**caractérisé en ce que**
le corps de réflecteur est revêtu de la matière réfléchissante.

10. Composant optoélectronique selon l'une quelconque des revendications précédentes,
**caractérisé en ce que**
le corps de réflecteur présente un renfoncement (30), **en ce que** le renfoncement fait partie de l'évidement du corps de boîtier et **en ce que** la matière réfléchissante est disposée sur une paroi (5) du renfoncement.

11. Composant optoélectronique selon l'une quelconque des revendications précédentes,
**caractérisé en ce que**
la matière réfléchissante est électriquement isolée de la matière de conducteur de raccordement.

12. Composant optoélectronique selon l'une quelconque des revendications précédentes,
**caractérisé en ce qu'**
une partie d'isolation (15) est disposée entre la partie de base et la partie de réflecteur.

13. Composant optoélectronique selon la revendication 12,
**caractérisé en ce que**
la partie d'isolation est préformée en étant séparée de la partie de base et de la partie de réflecteur.

14. Composant optoélectronique selon l'une quelconque des revendications précédentes,
**caractérisé en ce que**
la partie permettant l'adhérence est disposée sur la partie de base consécutivement à la partie de réflecteur.

15. Composant optoélectronique selon l'une quelconque des revendications précédentes,
**caractérisé en ce que**
la partie de réflecteur contient un métal.

16. Composant optoélectronique selon l'une quelconque des revendications précédentes,
**caractérisé en ce que**
la partie de base comprend un puits thermique (22) ou **en ce que** le composant optoélectronique présente un raccord thermique.

17. Composant optoélectronique selon la revendication 16,
**caractérisé en ce que**
le puits thermique est électriquement isolé de la puce à semi-conducteur.

18. Composant optoélectronique selon l'une quelconque des revendications précédentes,
**caractérisé en ce qu'**
une paroi de l'évidement est revêtue de la matière réfléchissante.
